# EUROPEAN PATENT APPLICATION

(11) **EP 1 749 613 A1**
(43) Date of publication of application: **07.02.2007**
(21) Application number: 06117907.3
(22) Date of filing: 26.07.2006
(51) Int. Cl.: B23K 20/02, H01L 21/603, G06K 19/07, B23K 101/40

(54) **Thermo compression bonding module with a thermode assembly and a bonding force feedback control device; thermo compression bonding apparatus comprising such module**

(30) Priority: 01.08.2005 US 194389
(71) Applicant: TYCO Electronics Corporation, Middletown, PA 17057-3163 (US)
(72) Inventor: Levannier, Vincent Frederic, Perkasie, PA 18944 (US); Borisuk, Peter John, Abington, PA 19001 (US); Ethen, Edward Jay, Collegeville, PA 19426 (US); Steckler, John Trent, Schwenksville, PA 19473 (US)
(74) Representative: Johnstone, Douglas Ian

(57) **Abstract**

The present application relates to a thermocompression bonding module (10) including a thermode assembly (12) configured to be mounted to a plate member (16). The thermode assembly (12) includes a heater assembly configured to apply a bonding force to an item (24) during a bonding operation and a control device coupled to the heater assembly (12) for adjusting the bonding force applied by the heater assembly (12) to the item (24). A force feedback device is positioned, relative to the heater assembly (12) in order to detect the bonding force applied by the heater assembly (12). The control device adjusts the bonding force based on the bonding force detected by the force feedback device.

## Description

This invention relates generally to thermocompression bonding, and more particularly, to apparatus and methods for thermocompression bonding.

Machines and manufacturing processes are known for manufacturing various items, such as flexible circuits. An example of a flexible circuit is a radio frequency identification (RFID) tags. An RFID tag is manufactured into a label and applied to a vast array of products in order that the products may be quickly and easily identified. Other types of flexible circuits are manufactured in a similar manner to RFID tags.

The flexible circuit generally includes a flexible substrate, such as a polyester film. During manufacturing, an adhesive is applied to the substrate, and a semiconductor die is applied to the adhesive. The substrate and die are transferred to a bonding station, and the die is bonded to the substrate. Typically, multiple circuits are manufactured simultaneously. For example, a film is supplied having multiple dies positioned thereon and the dies are bonded simultaneously using a single heating element. One conventional bonding process utilizes a thermocompression bonding apparatus to facilitate bonding. As such, heat and pressure are used to bond the die to the substrate. The conventional bonding process utilizes a pneumatic actuator to transfer the heating element onto the substrate during the bonding process.

The problem to be solved is that when the bonding apparatus is used to bond multiple dies, the heating element may not uniformly engage each die. As a result, at least some of the dies may not be fully or properly bonded. Additionally, at least some of the dies may be damaged during the bonding process due to overloading and providing too much pressure. The bonding force is measured and displayed such that an operator can manually adjust the force. Typically, the force is varied by adjusting a pneumatic pressure regulator, however, the force is uniformly adjusted along the entire apparatus.

The solution is provided by a thermocompression bonding module as disclosed herein including a thermode assembly configured to be mounted to a plate member. The thermode assembly includes a heater assembly configured to apply a bonding force to an item during a bonding operation and a control device coupled to the heater assembly for adjusting the bonding force applied by the heater assembly to the item. A force feedback device is positioned, relative to the heater assembly in order to detect the bonding force applied by the heater assembly. The control device adjusts the bonding force based on the bonding force detected by the force feedback device.

The invention will now be described by way of example with reference to the accompanying drawings in which:

Figure 1 is an isometric view of a thermocompression bonding station having a plurality of thermocompression bonding modules and formed in accordance with an exemplary embodiment of the present invention.

Figure 2 is an exploded view of an upper thermode assembly of one of the thermocompression bonding modules shown in Figure 1.

Figure 3 is a cross-sectional view of the upper thermode assembly shown in Figure 2.

Figure 4 is an assembled view of the upper thermode assembly shown in Figures 2 and 3.

Figure 5 is an exploded view of a lower thermode assembly of one of the thermocompression bonding modules shown in Figure 1.

Figure 6 is an assembled view of the lower thermode assembly shown in Figure 4.

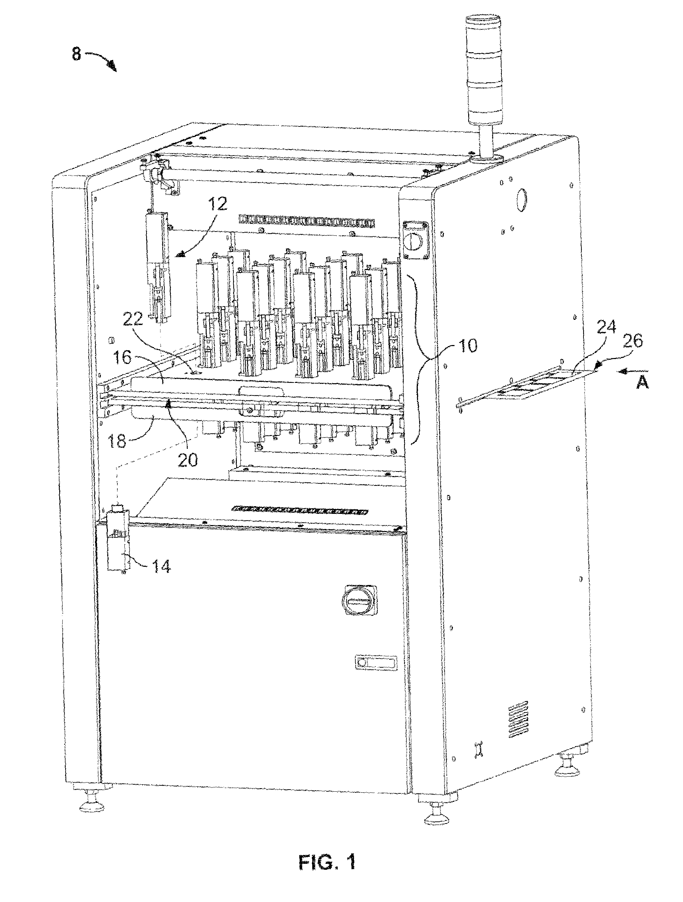

Figure 1 is an isometric view of a thermocompression bonding station or system 8 having a plurality of thermocompression bonding modules 10 and formed in accordance with an exemplary embodiment of the present invention. In one exemplary embodiment, the thermocompression bonding station 8 is used for manufacturing an item (e.g., a flexible circuit such as, for example, a radio frequency identification ("RFID") tag). However, the station 8 may be used for manufacturing other types of circuits or components. The station 8 represents one step within a series of manufacturing steps. Other manufacturing steps may be performed prior to the bonding step, e.g., to set up the circuit or component for the bonding step. Additionally, other manufacturing steps may be performed after the bonding step, e.g., to prepare a final product. The station 8 includes an assembly of thermocompression bonding modules 10 oriented in a matrix and used to manufacture a plurality of items simultaneously.

Each thermocompression bonding module 10 includes an upper thermode assembly 12 and a lower thermode assembly 14. The upper and lower thermode assemblies 12 and 14 are removably mounted to upper and lower plate members 16 and 18, respectively. The upper and lower thermode assemblies 12 and 14 may be removed from the plate members 16 and 18 for repair or replacement. Each of the plate members 16 and 18 are stationary and are spaced apart from one another such that a gap 20 is formed therebetween to define a bonding area. The plate members 16 and 18 are shown to be rectangular. Alternatively, the plate members 16 and 18 may have another shape such as triangular, square, circular, an irregular shape, or the like. The plate members 16 and 18 each include a matrix of apertures 22 extending therethrough. The apertures 22 open to the gap 20 formed between the plate members 16 and 18. A portion of each upper thermode assembly 12 extends through a corresponding aperture 22 in the upper plate member 16. Similarly, a portion of the lower thermode assembly 14 extends through a corresponding aperture 22 in the lower plate member 18. Each of the apertures 22, and thus the upper and lower thermode assemblies 12 and 14, are substantially aligned with one another. The plate members 16 and 18 include a plurality of apertures 22 oriented in a predetermined pattern of rows and columns. As such, a plurality of items may be simultaneously manufactured. Additionally, in one embodiment, the thermode assemblies 12 and 14 may be removed from the plate members 16 and 18, and then attached to plate members 16 and 18 having a different size or pattern of apertures. As such, a different pattern of circuits may be manufactured using the same thermode assemblies 12 and 14.

In an exemplary embodiment, the upper and lower thermode assemblies 12 and 14 cooperate to apply heat and pressure to join a component 24, such as semiconductor die, to a flexible substrate or film 26 to form a flexible circuit. The flexible substrate 26 is supplied as a continuous web of material to the gap 20 between the upper and lower plate members 16 and 18. The flexible substrate 26 may be a polyester film, however other types of substrates 26 may be used. During manufacture, the substrate 26 is positioned between the thermode assemblies 12 and 14 and the components 24 are joined to the substrate 26 using the thermode assemblies 12 and 14. In one embodiment, the component 24 is positioned on the substrate 26 prior to being positioned between the thermode assemblies 12 and 14. For example, an adhesive or other bonding agent may be applied to the substrate 26 and the component 24 may be positioned on the adhesive. The substrate 26 and components 24 are then transferred to the bonding station 8 where the thermode assemblies 12 and 14 apply heat and pressure to the component 24 to secure the component 24 to the substrate 26. The substrate 26 is moved along a conveyance direction (A) through the bonding station 8. The upper and lower thermode assemblies 12 and 14 are oriented along a longitudinal axis 70 extending perpendicular to the conveyance direction A.

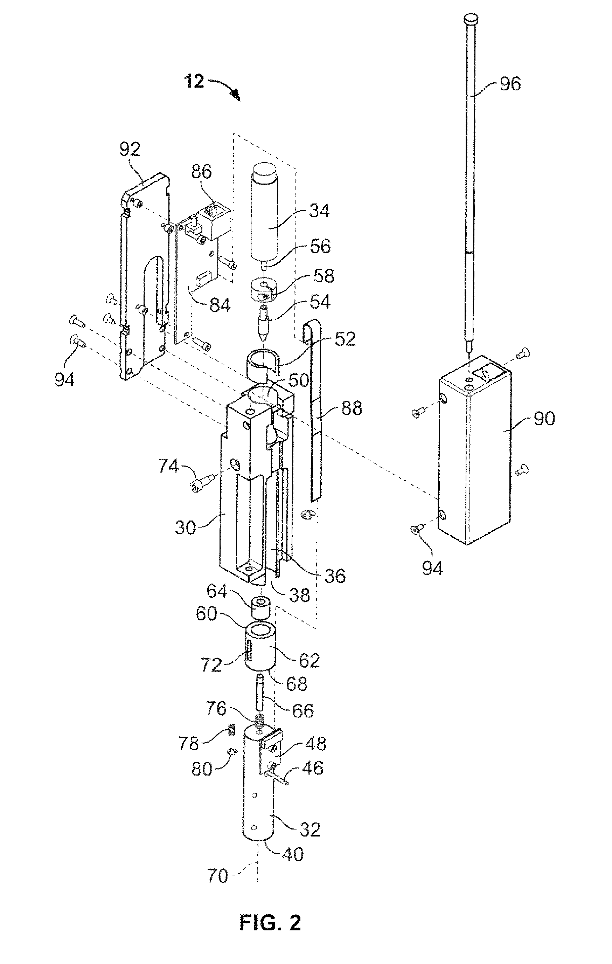

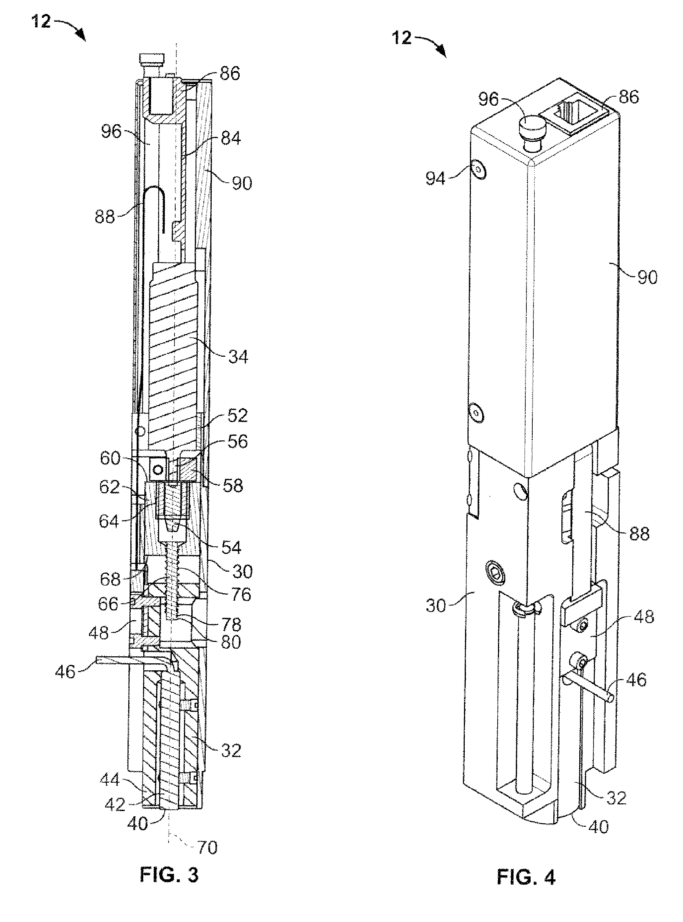

Figure 2 is an exploded view of an upper thermode assembly 12 of the thermocompression bonding module 10. Figure 3 is a cross sectional view of the upper thermode assembly 12. Figure 4 is an assembled view of the upper thermode assembly 12.

The upper thermode assembly 12 includes a housing 30 extending along an axis 70 and receiving a heater assembly 32 and a control device 34. The housing 30 includes a cavity 36 for receiving the heater assembly 32. The cavity 36 includes an open end 38 facing the bonding area such that a heating end 40 of the heater assembly 32 is exposed through the housing 30 to the gap 20. Moreover, the heating end 40 is exposed through the upper plate member 16 (shown in Figure 1) such that the heating end 40 may thermally engage the component 24 (shown in Figure 1).

As illustrated in Figure 3, an exemplary heater assembly 32 includes a heating element 42 surrounded by an insulative cover 44. A lead 46 extends from the heating element 42 through a portion of the insulative cover 44. The heating element 42 is a resistance heater such that electricity supplied to the heating element 42 via the lead 46 is used to increase the temperature of the heating element 42, particularly at the heating end 40 of the heating element 42. Alternatively, other types of heaters 42 may be used within the scope of the invention. The heating element 42 communicates with a control unit 48, such as a circuit board, to control the operational state of the heating element 42 and/or to control the temperature of the heating element 42. The control unit 48 is attached to the heater assembly 32 and may be exposed along the exterior of the housing 30.

In operation, the heater assembly 32 is used to apply heat and pressure, e.g., a bonding force, to the component 24 during the manufacturing process. As such, the heater assembly 32 facilitates bonding of the component 24 to the flexible substrate 26. The pressure is applied by engaging the heating element 42 with the component 24. The amount of pressure applied to the component 24 is controlled by the control device 34. In one embodiment, the control device 34 controls a position of the heater assembly 32 to control the amount of pressure on the component 24. Optionally, the control device 34 may be a servo motor for controlling the linear position of the heater assembly 32 with respect to the housing 30, as will be described below in more detail. The servo motor facilitates providing an accurate and immediate change in the amount of pressure applied to the component 24. Additionally, the servo motor may be continuously adjusted during the bonding process to apply an appropriate amount of pressure to the component during the bonding and/or curing process.

The control device 34 is coupled to the housing 30 and is substantially aligned with the heater assembly 32. Optionally, the control device 34 may be received in an opening 50 generally opposed from the open end 38 of the cavity 36. A positioning collar 52 may extend between the control device 34 and the walls of the housing within the opening 50 to align and/or secure the control device 34 within the opening 50.

A series of components may be operatively connected between the control device 34, e.g. the servo motor, and the heater assembly 32 to facilitate moving or positioning the heater assembly 32 within the housing 30. For example, a lead screw 54 is attached to a shaft 56 of the control device 34. A clamping collar 58 may be used to clamp the lead screw 54 to the shaft 56. The lead screw 54 is received within a first end 60 of a sleeve 62. A threaded insert 64 is positioned within the sleeve 62, and the lead screw 54 is received within the threaded insert 64. Alternatively, the sleeve 62 itself may be threaded. A guide shaft 66 is connected to a second end 68 of sleeve 62. The guide shaft 66 is also connected to the heater assembly 32. The guide shaft 66 extends through the insulative cover 44 of the heater assembly 32. As such, the control device 34 is operatively coupled to the heater assembly 32 via the various components. Optionally, less than all of the described components may be used to connect the control device 34 and the heater assembly 32, or alternatively, additional or different components may be utilized. Optionally, the control device 34 may be coupled directly to the heater assembly 32.

In operation, and as may be evident by reference to Figure 3, the control device 34 facilitates controlling a position of the heater assembly 32. For example, the various components connecting the control device 34 and the heater assembly 32 transfer a rotational movement of the shaft 56 of the control device 34 to a linear movement of the heater assembly 32 along the longitudinal axis 70. The longitudinal axis 70 extends substantially perpendicular to the heating end 40 of the heating element 42. Each of the heater assembly 32, the guide shaft 66, the sleeve 62, the lead screw 54 and the shaft 56 extend along and substantially parallel to the longitudinal axis. In operation, the rotational movement of the shaft 56 is transferred to the lead screw 54. The lead screw 54 is threadably coupled to the threaded insert 64. As the lead screw 54 rotates, the threaded insert 64 is translated along the lead screw 54 in an axial direction along the longitudinal axis 70. This translational movement of the threaded insert 64 is transferred directly to the sleeve 62, the guide shaft 66, and ultimately, to the heater assembly 32. For example, rotational movement of the shaft 56 in a first direction, such as in a clockwise direction, causes the heater assembly 32 to move generally away from the control device 34. Similarly, rotational movement of the shaft 56 in a second direction, such as in a counter-clockwise direction, causes the heater assembly 32 to move generally closer to the control device 34. Optionally, the sleeve 62 may include an elongated slot 72 extending substantially parallel to the longitudinal axis 70. A set screw 74 may be received in the slot 72 to resist rotational movement of the sleeve 62. Alternatively, the set screw 74 may move within the slot 72 such that the sleeve 62 is moveable in the axial direction.

To reduce a risk of damage to the component 24, first and second spring members 76 and 78 surround the guide shaft 66. The first spring member 76 is positioned between the insulative cover 44 and the sleeve 62. The second spring member 78 is positioned within the heater assembly 32 between the insulative cover 44 and retention ring 80. The spring members 76 and 78 facilitate controlling the bonding force or pressure the heater assembly 32 transfers to the component 24. Additionally, the spring members 76 and 78 reduce an initial impact force transferred from the heater assembly 32 to the component 24 when the heater assembly 32 first engages the component 24. As such, the risk of damage to the component 24 is reduced.

The upper thermode assembly 12 also includes a control system for controlling the heating element 42 and the control device 34. The control system may include a circuit board 84 mounted within the upper thermode assembly 12. The circuit board 84 is configured to communicate externally with a machine (shown in Figure 1) controlling the manufacturing processes. The circuit board 84 communicates via a connector 86, such as, for example, an RJ11 connector. Additionally, the circuit board 84 may communicate with the control device 34. As such, the control device 34 may be controlled, for example, by the machine. The circuit board 84 may also communicate with the heating element 42. As a result, the heating element 42 may be controlled, for example, by the machine. A flexible ribbon cable 88 extends between the circuit board 84 and the heater assembly 32, and more particularly, the control unit 48.

The upper thermode assembly 12 includes a cover 90 surrounding a portion of the housing 30 and the control device 34. The cover 90 includes a backing plate 92 that is coupled thereto. The cover 90 and backing plate 92 may be attached to one another and the housing 30 by a plurality of fastening members 94, such as screws. The upper thermode assembly 12 includes an elongated thumb screw 96. The thumb screw 96 couples the cover 90 to the housing 30. The thumb screw 96 is used to mount the upper thermode assembly 12 to the upper plate member 16.

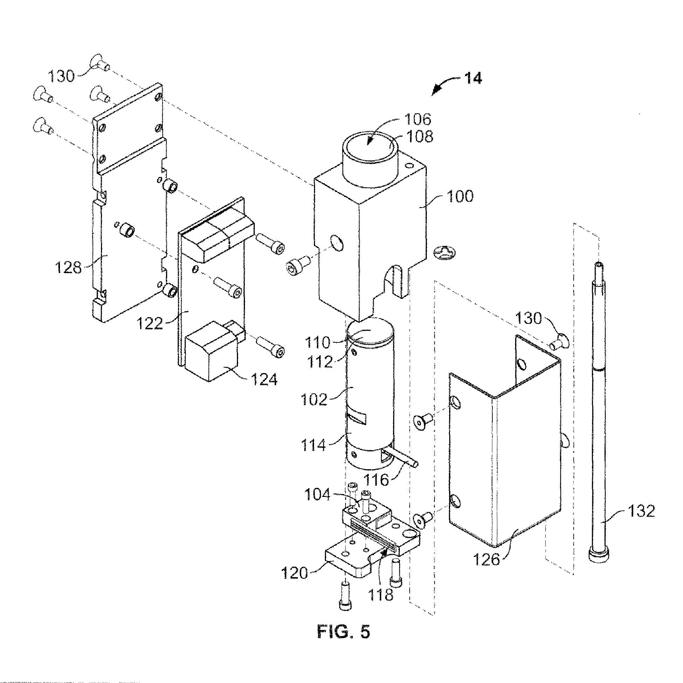

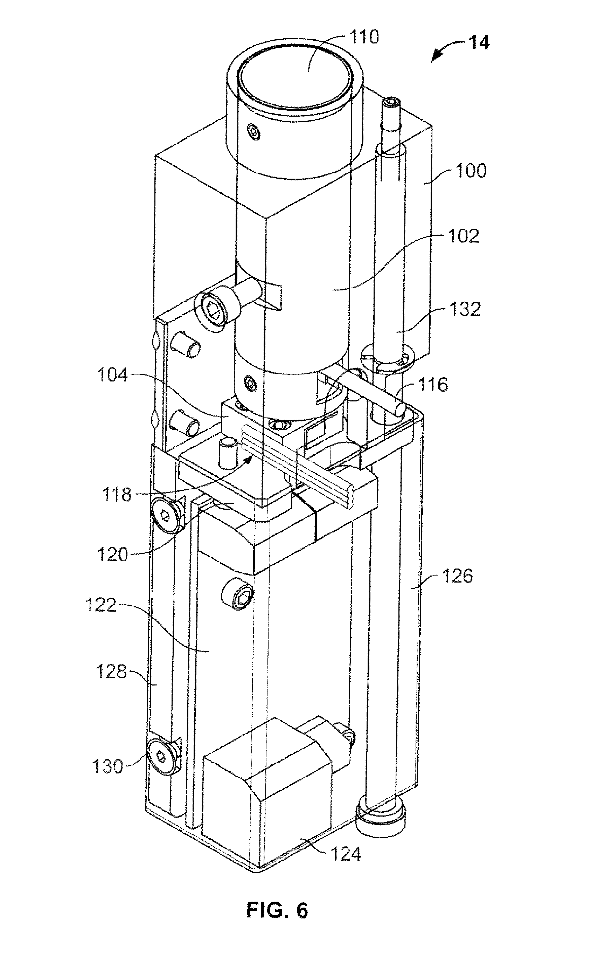

Figure 5 is an exploded view of a lower thermode assembly 14 of the thermocompression bonding module 10. Figure 6 is an assembled view of the lower thermode assembly 14. The lower thermode assembly 14 is aligned along the same longitudinal axis 70 as a corresponding upper thermode assembly 12 (shown in Figures 1-4).

The lower thermode assembly 14 includes a housing 100 (shown in phantom in Figure 6) for receiving a heater assembly 102 and a force feedback device 104, such as, for example, a load cell, a force transducer, or the like. The housing 100 includes a cavity 106 for receiving the heater assembly 102. The cavity 106 includes an open end 108 such that a heating end 110 of the heater assembly 102 is exposed through the housing 100. The heating end 110 is exposed through the lower plate member 18 (shown in Figure 1) such that the heating end 110 may thermally engage the component 24 (shown in Figure 1).

The heater assembly 102 facilitates heating an underside of the substrate 26 (shown in Figure 1). As such, heat supplied by the upper heating element 42 (shown in Figures 2-4) to the component 24 and substrate 26, which would otherwise be dissipated and lost, is maintained. As a result, the upper heating element 42 may function at a lower operating temperature to bond the component 24 to the substrate 26. The bonding time may be reduced by applying additional heat to the underside of the substrate 26 by heating the substrate more quickly, as compared to using a single heat source. Alternatively, the lower thermode assembly 14 does not include a heater assembly, such as heater assembly 102. Rather, the lower thermode assembly 14 includes a flat surface for supporting the component 24 as the upper heater assembly 32 (shown in Figures 2-4) engages and applies a force to the component 24.

The heater assembly 102 is similar to the heater assembly 32 shown in Figures 2-4. The heater assembly 102 includes a heating element 112 surrounded by an insulative cover 114. A lead 116 extends from the heating element 112 through a portion of the insulative cover 114. The heating element 112 communicates with a control unit 118, such as a circuit board, to control the operational state of the heating element 112 and/or to control the temperature of the heating element 112. In one embodiment, the heating element 112 may be operated at a lower temperature than the upper heating element 42. As a result, the heating element 112 may be operated at a lower cost or a lower cost heating element 112 may be used.

In operation, the heater assembly 102 is stationary such that pressure may be applied to the substrate 26 and component 24 by the upper heater assembly 32. As the upper heater assembly 32 presses on the substrate 26, the amount of force applied is detected by the force feedback device 104. The force feedback device 104 interfaces with the heater assembly 102 such that the force is transferred directly from the heater assembly 102 to the force feedback device 104. In one embodiment, the force feedback device 104 is attached to a base 120. The base 120 may be attached to an end of the housing 100.

The lower thermode assembly 14 also includes a control system for controlling the heating element 112 and/or the force feedback device 104. The control system includes a circuit board 122 mounted within the lower thermode assembly 14. The circuit board 122 is configured to communicate externally with the machine controlling the manufacturing processes. In one embodiment, the circuit board 122 communicates via a connector 124, such as, for example, an RJ11 connector. Additionally, the circuit board 122 may communicate with the force feedback device 104. For example, the force feedback device 104 may transmit a signal relating to the amount of force detected to the machine via the connector 124. This signal may then be used by the machine to transmit a corresponding signal to the upper thermode assembly 12, such as a signal relating to a desired change in force. For example, the signal may be transmitted to the control device 34 (shown in Figure 2) to increase or decrease the pressure applied to the component 24 and substrate 26. As a result, the operation of the control device 34 in the upper thermode assembly 12 may be controlled based on the amount of force detected by the force feedback device 104 in the lower thermode assembly 14.

Moreover, as indicated above with respect to Figure 1, the bonding station 8 includes multiple upper and lower thermode assemblies 12 and 14 operating as single units. Each unit, i.e. a single upper thermode assembly 12 and a single lower thermode assembly 14, may be individually controlled within the bonding station 8. In other words, each unit may operate at a different temperature or pressure depending on the particular component 24 and substrate 26 being manufactured. As a result, the products may be more uniformly and accurately produced.

The lower thermode assembly 14 includes a cover 126 surrounding a portion of the housing 100 and the circuit board 122. The cover 126 includes a backing plate 128 that is coupled thereto. The cover 126 and backing plate 128 are attached to one another and the housing 100 by a plurality of fastening members 130, such as screws. Additionally, the lower thermode assembly 14 includes an elongated thumb screw 132. The thumb screw 132 couples the cover 126 to the housing 100. Additionally, the thumb screw 132 is used to mount the lower thermode assembly 14 to the lower plate member 18 (shown in Figure 1).

While the invention has been described in terms of various specific embodiments, those skilled in the art will recognize that the invention can be practiced with modification within the scope of the claims.

## Claims

1. A thermocompression bonding module (10), comprising:
a thermode assembly (12) configured to be mounted to a plate member (16), said thermode assembly (12) comprising a heater assembly (32) configured to apply a bonding force to an item (24) during a bonding operation, **characterized by**:
a control device (34) coupled to said heater assembly (32) for adjusting the bonding force applied by said heater assembly (32) to the item (24); and a force feedback device (104) positioned relative to said heater assembly (32) in order to detect the bonding force applied by said heater assembly (32), said control device (34) being adapted to adjust the bonding force based on the bonding force detected by said force feedback device (104).

2. The thermocompression bonding module (10) of claim 1, wherein said control device (34) is configured to adjust a position of said heater assembly (32) with respect to the plate member (16).

3. The thermocompression bonding module (10) of claim 1 or 2, wherein said control device (34) comprises a servo motor for controlling a linear position of said heater assembly (32) with respect to the plate member (16) along a longitudinal axis (70) extending perpendicular to a conveyance direction (A) along which the item (24) is moved.

4. The thermocompression bonding module (10) of any preceding claim, wherein said heater assembly (32) is movable in an axial direction by said control device (34), said force feedback device (104) is substantially aligned with said heater assembly (32) such that said force feedback device (104) detects the bonding force applied in the direction of movement of said heater assembly (32).

5. The thermocompression bonding module (10) of any preceding claim, wherein said heater assembly (32) comprises a heating element (42) and an insulator (44) surrounding said heating element (42), said heating element (42) is exposed through a portion of said insulator (44) such that said heating element (42) is configured to engage the item (24).

6. The thermocompression bonding module (10) of any preceding claim, further comprising a second heater assembly (102) substantially aligned with said heater assembly (34) in a direction of the bonding force such that the item (24) extends between said heater assembly (32) and said second heater assembly (102).

7. The thermocompression bonding module (10) of any preceding claim, wherein said force feedback device (104) comprises a load cell.

8. A thermocompression bonding apparatus (8), comprising: an upper plate member (16) and a lower plate member (18), wherein said upper plate member (16) is separated from said lower plate member (18) by a gap (20), the gap (20) being configured to receive an item (24) to be bonded, and **characterized by**:
one or more thermocompression modules (10) having an upper thermode assembly (12) configured to be mounted to said upper plate member (16), and a lower thermode assembly (14) configured to be mounted to said bottom plate member (18), said upper thermode assembly (12) comprising a heater assembly (32), configured to apply a bonding force to the item (24) during a bonding operation, and a control device (34) coupled to said heater assembly (32) for adjusting the bonding force applied by said heater assembly (32) to the item (24); and said lower thermode assembly (14) comprising a force feedback device (104) positioned relative to said heater assembly (32) in order to detect the bonding force applied by said heater assembly (32), said control device (34) adjusting the bonding force based on the bonding force detected by said force feedback device (104).

9. The thermocompression bonding apparatus (8) of claim 8, wherein the one or more thermocompression modules (10) are configured to be removably mounted to said upper plate member (16) and said lower plate member (18).

10. The thermocompression bonding apparatus (8) of claim 8 or 9, wherein said control device (34) is configured to adjust a position of said heater assembly (32) with respect to said upper plate member (16).

11. The thermocompression bonding apparatus (8) of claim 8, 9 or 10, wherein said control device (34) comprises a servo motor for controlling a linear position of said heater assembly (32) with respect to the upper plate member (16) along a longitudinal axis (70) extending perpendicular to a conveyance direction (A) along which the item (24) is moved.

12. The thermocompression bonding apparatus (8) of claim 8, 9 10 or 11, wherein said lower thermode assembly (14) comprises a second heater assembly (102) configured to be mounted to said lower plate member (18) such that said second heater assembly (102) is substantially aligned with said heater assembly (32) in a direction of the bonding force such that the item (24) extends between said heater assembly (32) and said second heater assembly (102).
